# EUROPEAN PATENT APPLICATION

(11) **EP 2 136 393 A1**
(43) Date of publication of application: **23.12.2009**
(21) Application number: 07737036.9
(22) Date of filing: 10.04.2007
(51) Int. Cl.: H01L 21/52, C09J 7/00, C09J 133/00, C09J 163/00

(54) **ADHESIVE FILM FOR SEMICONDUCTOR AND SEMICONDUCTOR DEVICE MADE WITH THE SAME**

(71) Applicant: Sumitomo Bakelite Co., Ltd., Shinagawa-ku Tokyo 140-0002 (JP)
(72) Inventor: YASUDA, Hiroyuki, Tokyo 140-0002 (JP); YOSHIDA, Masato, Tokyo 140-0002 (JP)
(74) Representative: Müller, Christian Stefan Gerd
(86) International application number: PCT/JP2007/000379
(87) International publication number: WO 2008/129590

(57) **Abstract**

There isprovidedan adhesive film for a semiconductor, comprising a thermoplastic resin (A), an epoxy resin (B) and a curing agent (C), wherein a minimum melt viscosity of said adhesive film for a semiconductor is 0.1 Pa·s to 500 Pa·s both inclusive in a temperature range of 50 °C to 180 °C both inclusive at a temperature-rise rate of 10 °C/min from room temperature and a content of volatile component is 5.0 % or less.

## Description

### TECHNICAL FIELD

The present invention relates to an adhesive film for a semiconductor and a semiconductor device therewith.

### BACKGROUND ART

An organic substrate such as a bismaleimide-triazine substrate and a polyimide substrate has been increasingly used instead of a lead frame in recent semiconductor packages.

The above semiconductor package contains, as components, a semiconductor element, a supporting member for mounting the semiconductor element and a encapsulation material, and, for example, a polyimide series adhesive film for a semiconductor has been used for bonding the semiconductor element and the supporting member for a semiconductor element.
[Patent Documents 1] Japanese Laid-open patent publication NO. 1994-264035
[Patent Documents 2] Japanese Laid-open patent publication NO. 2000-200793
[Patent Documents 3] Japanese Laid-open patent publication NO. 2003-96426

### DISCLOSURE OF THE INVENTION

However, the related art described in the above patent documents has rooms for improvement in terms of the following points.
There has been a problem that when a known adhesive film for a semiconductor is used for prepare a semiconductor device having a structure where semiconductor elements and an organic substrate are bonded, cracks tend to be formed, leading to low reliability.
For the purpose of the present invention, there has been found that the above semiconductor device can be made more reliable by controlling a minimummelt viscosity to 0.1 Pa·s to 500 Pa·s both inclusive in a temperature range of 50 °C to 180 °C both inclusive at a temperature-rise rate of 10 °C/ min from room temperature and a content of volatile component to 5.0 % or less.

According to the present invention, there is provided an adhesive film for a semiconductor, comprising a thermoplastic resin (A), an epoxy resin (B) and a curing agent (C), wherein a minimum melt viscosity of the adhesive film for a semiconductor is 0.1 Pa·s to 500 Pa·s both inclusive in a temperature range of 50 °C to 180 °C both inclusive at a temperature-rise rate of 10 °C/min from room temperature and a content of volatile materials is 5.0 % or less.
An adhesive film for a semiconductor of the present invention has a particular range of a minimum melt viscosity in a particular temperature range. The temperature range is that which can be set when applying a film, and when an adhesive film for a semiconductor of the present invention is applied at a temperature near that giving the minimum melt viscosity, a melt viscosity can be appropriately low to fill gap on a circuit substrate with the adhesive with no voids. Since a filling material containing much volatiles generates gases which cause cracks, a content of volatiles can be at the same time controlled to 5.0 % or less, to prevent void formation due to gas generation.

A semiconductor adhesive film of the present invention may be used to closely bond a semiconductor element to a supporting member for mounting a semiconductor element, particularly an organicsubstrate with no voids, so that a highly reliable semiconductor device can be provided.

### BRIEF DESCRIPTION OF THE DRAWINGS

These and other objectives, features and advantages will be further clearly understood with reference to the suitable embodiments described below and the accompanying drawings below.

FIG. 1 schematically shows a relationship of a melt viscosity to a temperature for an adhesive film for a semiconductor of the present invention.
FIG. 2 is a cross-sectional view schematically illustrating an example of a semiconductor device of the present invention.

### BEST MODE FOR CARRYING OUT THE INVENTION

An adhesive film for a semiconductor of the present invention is an adhesive film for a semiconductor, comprising a thermoplastic resin (A), an epoxy resin (B) and a curing agent (C), wherein a minimum melt viscosity of the adhesive film for a semiconductor is 0.1 Pa·s to 500 Pa·s both inclusive in a temperature range of 50 °C to 180 °C both inclusive at a temperature-rise rate of 10 °C/min from room temperature and a content of volatile materials is 5.0 % or less.

When a semiconductor device is prepared by bonding semiconductor elements to a supporting member for mounting a semiconductor element using a conventional adhesive film for a semiconductor, a polyimide series semiconductor adhesive film, there have been problems in terms of reliability such as generation of cracks in an adhesion interface. We have intensely investigated conventional semiconductor devices taking advantage of cross-sectional analysis and scan acoustic tomography (SAT), and have finally found that when using a conventional adhesive film for a semiconductor, a void is formedbetween a semiconductor element and a supporting member for a semiconductor element immediately after preparing a semiconductor device.

The phenomenon has been prominent when using an organic substrate having a metal interconnect in its surface as a supporting member for mounting a semiconductor element. It can be considered that when a metal interconnect is formed on an organic substrate, a thickness of the interconnect causes gap on a substrate, which cannot be sufficiently filled with an adhesive film for a semiconductor during bonding with a semiconductor element, leading to voids and thus to deterioration in reliability.

Assuming that insufficient filling of irregularity might be due to a high melt viscosity of an adhesive film for a semiconductor during adhesion, we measured a melt viscosity of a polyimide semiconductor adhesive film as a conventional adhesive film for a semiconductor, and found that a melt viscosity was about 4000 Pa·s at an adhesion temperature.
We have found that in the present invention, reliability of a semiconductor device can be improved by properly filling the above voids by adjusting a melt viscosity during adhesion of an adhesive film for a semiconductor to 0.1 Pa·s to 500 Pa·s both inclusive which is adequately lower than a conventional melt viscosity and controlling a content of volatiles to 5.0 % or less. Furthermore, thermal damage of a semiconductor element can be prevented by adjusting a temperature giving such a melt viscosity to 50 °C to 180 °C both inclusive which is relatively lower than a conventional adhesion temperature.

In the present invention, if a minimummelt viscosity determined in a range of 50 °C to 180 °C both inclusive at a temperature-rise rate of 10 °C/min is 0.1 Pa·s to 500 Pa·s both inclusive, a temperature near that giving the minimum melt viscosity can be employed as an adhesion temperature to select a proper adhesion temperature.

A melt viscosity in the present invention can be determined by applying a shear force at a frequency of 1 Hz to a film sample at a temperature-rise rate of 10 °C/min using, for example, a rheometer which is a viscoelasticity measuring instrument.

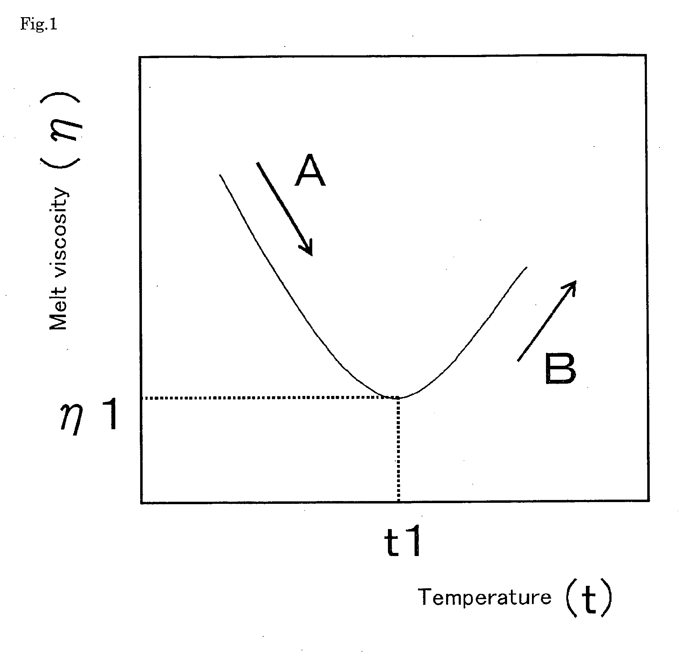

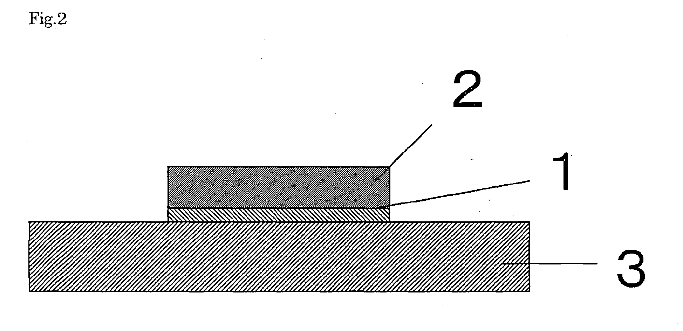

FIG. 1 schematically shows an example of relationship of a melt viscosity to a temperature for an adhesive film for a semiconductor of the present invention. The ordinate represents a melt viscosity (η) and the abscissa represents a temperature (t). An adhesive film for a semiconductor of the present invention has a feature that as shown in FIG. 1, in the course of heating the adhesive film for a semiconductor from 25 °C to its melting temperature at a temperature-rise rate of 10 °C/min, a melt viscosity reduces in the initial stage (Arrow A in the figure), reaches the minimum melt viscosity (η1) at a certain temperature (t1) and then increases (Arrow B in the figure). FIG. 2 shows an example of a semiconductor device having a adhesive film for a semiconductor of the present invention. As shown in FIG. 2, a semiconductor element (2) and a supporting member for mounting a semiconductor element (3) are bonded via an adhesive film for a semiconductor (1).

Here, the adhesive film for a semiconductor is designed to have a minimum melt viscosity of 0.1 Pa·s to 500 Pa·s both inclusive in a range of 50 °C to 180 °C. The melt viscosity is preferably 1 Pa·s to 100 Pa·s both inclusive, particularly 5 Pa·s to 50 Pa·s both inclusive. When it is 500 Pa·s or less, flowability during thermocompression bonding is so improved that voids between the film and a circuit formed in the organic substrate can be filled. When it is 0.1 Pa·s or more, excessive flow of the adhesive film for a semiconductor can be prevented to reduce a risk of contamination of the semiconductor element and void formation can be prevented due to entrainment of gases from the organic substrate by the adhesive film for a semiconductor during thermally curing the adhesive film for a semiconductor.

The above minimum melt viscosity can be achieved by a method using a thermoplastic resin (A), an epoxy resin (B) and a curing agent (C), where the epoxy resin (B) or the curing agent (C) is a highly-flowable low-molecular monomer containing which is liquid at 25 °C. Here, by combining a monomer which is solid at 25 °C, a minimum melt viscosity can be designed to be in the above range while preventing increase in tackiness of the adhesive film for a semiconductor, resulting in improvement in workability.
Alternatively, a component such as a monomer having an intramolecular radiation polymerizable carbon-carbon double bond may be added, which is inert to the thermoplastic resin (A), the epoxy resin (B) and the curing agent (C) and is liquid at 25 °C. Specific examples include ultraviolet curing resins consisting mainly of an acrylic compound; ultraviolet curing resins consisting mainly of an urethane acrylate oligomer or a polyester urethane acrylate oligomer; and ultraviolet curing resins consisting mainly of at least one selected from the group consisting of epoxy resins and vinylphenol resins.
In addition, the minimum viscosity is obtained by increasing a content of the epoxy resin (B) and the curing agent (C) to the thermoplastic resin (A). Specifically, it can be obtained when 0.1≤a/(a+b+c)≤0.5, wherein a content of the thermoplastic resin (A) is "a" parts by weight; a content of the epoxy resin (B) is "b" parts by weight; and a content of the curing agent (C) is "c" parts by weight.

A content of volatiles in an adhesive film for a semiconductor of the present invention is 5.0 % or less. The volatiles may include an unreacted thermosetting resin contained in the adhesive film for a semiconductor during thermally curing the adhesive film for a semiconductor and its decomposition products and materials not involved in the thermal curing reaction and their decomposition products. Particularly, by using a film free of materials not involved in the thermal curing reaction, a content of the volatiles can be 5.0 % or less. Specific examples of the volatiles include ultraviolet curing resins such as compounds having a (meth) acrylic group; and ultraviolet curing initiators such as benzophenone, acetophenone, benzoin, benzoin isobutyl ether, benzoin methyl benzoate, benzoin benzoic acid, benzoin methyl ether, benzyl phenyl sulfide, benzil, dibenzyl and diacetyl.
The amount of the volatiles in the present invention is, for example, determined as a weight reduction in an adhesive film for a semiconductor cut into a 50 mm × 50 mm square after heating it at 200 °C for 2 hours. A content of the volatiles in the present invention is preferably 5. 0 % or less, particularly preferably 3. 0 % or less. Thus, when a melt viscosity of an adhesive film for a semiconductor is reduced during curing the film by heating, no gaseous components are generated from the film, so that the adhesive film for a semiconductor can be cured without void formation, and therefore, when a semiconductor device is heated to a high temperature by a reflow oven during mounting the device on a printed board, crack formation due to thermal expansion of voids in the film can be prevented.

After adhesion, the adhesive film for a semiconductor of the present invention has a die-shear strength of preferably 1 MPa or more, more preferably 2 MPa or more. Thus, when a semiconductor device is heated to a high temperature by a reflow oven during mounting the device on a printed board, detachment due to adhesion force reduction can be prevented, resulting in prevention of reflow cracks due to detachment.
A die-shear strength is measured using a sample prepared by sandwiching an adhesive film for a semiconductor between a silicon chip with a size of 4×4 mm and a thickness of 550 µm and a bismaleimide-triazine substrate coated with a solder resist (TAIYO INK MFG Co. Ltd.: trade name AUS308), which is then thermally compressed at 130 °C and 5N for 1 sec and then thermally cured, anddetermined as a shear strength observed by holding the sample on a hot plate at 260 °C for 20 sec and then applying to the sample a shear stress at a rate of 0.5 mm/min from the silicon chip side.

The present invention relates to an adhesive film for a semiconductor containing a thermoplastic resin (A), an epoxy resin (B) and a curing agent (C). There will be described each component in the adhesive film for a semiconductor of the present invention. The following description is for illustrative purposes only and does not limit the present invention in any manner.

As used herein, a thermoplastic resin (A) means a thermoplastic polymer resin, which typically has a principal chain skeleton having a linear chemical structure. Specific examples include polyimide resins, polyimide type resins such as polyether imide resins, polyamide resins, polyamide type resins such as polyamide-imide resin, and acrylic resins such as acrylate copolymers.

Among these, acrylic resins are preferable. An acrylic resin can improve initial adhesiveness because of its low glass-transition temperature. Herein, the term "initial adhesiveness" means adhesiveness in an initial stage of adhesion of a semiconductor element to a supporting member in an adhesive film for a semiconductor, that is, adhesiveness before curing an adhesive film for a semiconductor.

An acrylic resin means a resin based on acrylic acid and its derivative as main starting monomers. Specific examples include polymers of acrylic acid, methacrylic acid, acrylates such as methyl acrylate and ethyl acrylate, methacrylates such as methyl methacrylate and ethyl methacrylate, acrylonitrile, acrylamide and the like, and copolymers with another monomer.
In the present invention, acrylic resins (particularly, acrylate copolymers) based on a compound having, for example, an epoxy group, a hydroxy group, a carboxyl group and a nitrile group, are preferable. Thus, adhesiveness to a bonded material such as a semiconductor element can be improved. Examples of a compound having any of the above functional groups include glycidyl methacrylate having a glycidyl ether group, hydroxy methacrylates having a hydroxy group, carboxymethacrylates having a carboxyl group and acrylonitrile having a nitrile group. Among these, acrylate copolymers having a nitrile group are particularly preferable. Thus, adhesiveness to a bonded material can be particularly improved.

A content of a compound having the above functional group is, but not limited to, preferably 0.5 % by weight to 40 % by weight both inclusive, particularly preferably 5 % by weight to 30 % by weight both inclusive to the total of the acrylic resin. A content of 0.5 % by weight or more may lead to effective improvement of adhesiveness, while a 40 % by weight or less may lead to sufficiently controlled adhesion force to improve workability.

A weight-average molecular weight of the thermoplastic resin (A) used in the present invention is preferably 100,000 or more, particularly preferably 150,000 to 1,000,000. When a weight-average molecular weight is within the above range, depositability of an adhesive film for a semiconductor may be particularly improved. Furthermore, when a weight-average molecular weight is within the above range, a thermoplastic resin alone does not substantially exhibit curing behavior by heating even when the resin has a thermoplastic functional group.

A glass-transition temperature of the thermoplastic resin (A) used in the present invention is, but not limited to, preferably -20 °C to 60 °C both inclusive, particularly preferably -10 °C to 50 °C both inclusive. When a glass-transition temperature is -20 °C or higher an adhesion force of the adhesive film for a semiconductor may be controlled to effectively improve workability. When a glass-transition temperature is 60 °C or lower, low-temperature adhesiveness may be improved.

A content of the thermoplastic resin (A) used in the present invention is, but not limited to, preferably 0.1≤a/(a+b+c)≤0.5, more preferably 0.15≤a/(a+b+c)≤0.4, particularly preferably 0.2≤a/(a+b+c)≤0.3, wherein "a", "b" and "c" are contents of the thermoplastic resin (A), the epoxy resin (B) and the curing agent (C) in parts by weight, respectively. When it is 0.1 or more, depositability of the resin component is improved and tenacity of the adhesive film for a semiconductor is improved. When it is 0.5 or less, a film adhesive may have so improved flowability during adhesion that circuit steps in an organic substrate may be filled with the film adhesive during thermocompression bonding.

An epoxy resin (B) used in the present invention refers to any of a monomer, an oligomer and a polymer. Examples include biphenyl type epoxy resins, bisphenol-A type epoxy resins, bisphenol-F type epoxy resins, hydrogenated bisphenol-A type epoxy resins, aliphatic type epoxy resins, stilbene type epoxy resins, ortho-cresol novolac type epoxy resins, phenolnovolac type epoxy resins, modified phenol type epoxy resins, triphenolmethane type epoxy resins, alkyl-modified triphenolmethane type epoxy resins, triazine-core-containing epoxy resins, naphthalene type epoxy resins, dicyclopentadiene type epoxy resins, dicyclopentadiene-modified phenol type epoxy resins, glycidylamine type epoxy resins, bisphenol-A novolac type epoxy resins, bromophenolnovolac type epoxy resins and naphthol type epoxy resins.

A content of the epoxy resin (B) is preferably 10 parts by weight or more, particularly preferably 20 parts by weight to 10 parts by weight of the thermoplastic resin (A). Thus, flowability during adhesion may be improved. A content of the epoxy resin (B) is preferably 100 parts by weight or less, particularly preferably 50 parts by weight or less to 10 parts by weight of the thermoplastic resin (A). Thus, tenacity of an adhesive film for a semiconductor may be improved.

The curing agent (C) used in the present invention may be appropriately selected from those which act as a curing agent for an epoxy resin. Specific examples of the curing agent (C) used in the present invention include amine type curing agents including aliphatic polyamines such as diethylenetriamine, triethylenetetramine and meta-xylylenediamine, aromatic polyamines such as diaminodiphenylmethane, m-phenylenediamine and diaminodiphenyl sulfone, and polyamine compounds such as dicyandiamide and organic acid dihydrazide; acid anhydride type curing agents including aliphatic anhydrides such as hexahydrophthalic anhydride and methyltetrahydrophthalic anhydride and aromatic acid anhydrides such as trimellitic anhydride and pyromellitic-benzophenonetetracarboxylic anhydride; phenol type curing agents such as phenolnovolac resins, cresol novolac resins, phenolaralkyl (containing a phenylene or biphenylene skeleton) resins, naphtholaralkyl resins, triphenolmethane resins, dicyclopentadiene type phenol resins, bis(mono- or di-t-butylphenol)propane, methylenebis(2-propenyl)phenol, propylenebis(2-propenyl)phenol, bis[(2-propenyloxy)phenyl]methane, bis[(2-propenyloxy)phenyl]propane, 4,4'-(1-methylethylidene)bis[2-(2-propenyl)phenol], 4,4'-(1-methylethylidene)bis[2-(1-phenylethyl)phenol], 4,4'-(1-methylethylidene)bis[2-methyl-6-hydroxymethylphenol], 4,4'-(1-methylethylidene)bis[2-methyl-6-(2-propenyl)phenol] and 4,4'-(1-methyltetradecylidene)bisphenol.
In the present invention, it is preferable to use a liquid curing agent at 25 °C having a viscosity of 30 Pa·s (30,000 cps) or less. Further preferable is a liquid curing agent at 25 °C having a viscosity of 10 Pa·s (10, 000 cps) or less. By controlling a viscosity of a curing agent used in the present invention at 25 °C below a certain value, initial adhesiveness and reliability may be improved.

Preferable curing agents (C) used in the present include liquid phenol compounds. Specificexamplesofaliquidphenolcompoundinclude bis(mono- or di-t-butylphenol)propane, methylenebis(2-propenyl)phenol, propylenebis(2-propenyl)phenol, bis[(2-propenyloxy)phenyl]methane, bis[(2-propenyloxy)phenyl]propane , 4,4'-(1-methylethylidene)bis[2-(2-propenyl)phenol], 4,4'-(1-methylethylidene)bis[2-(1-phenylethyl)phenol], 4,4'-(1-methylethylidene)bis[2-methyl-6-hydroxymethylphenol], 4,4'-(1-methylethylidene)bis[2-methyl-6-(2-propenyl)phenol] and 4,4'-(1-methyltetradecylidene)bisphenol. A viscosity of such a liquid phenol compound may be controlled by a nuclear number "n" and/or the type of a substituent on a benzene ring.

A content of a curing agent (C) used in the present invention may be determined by calculating a ratio of an epoxy equivalent to a curing agent equivalent. It is preferable that a ratio of an epoxy ratio of the epoxy resin (B) to a functional group equivalent of the curing agent (C) (for example, hydroxy equivalent in a phenol resin) is 0.5 or more, particularly 0.7 or more. Thus, heat resistance of an adhesive film for a semiconductor may be improved. The ratio is preferably 1.5 or less, particularly 1.3 or less. Thus, storage stability of an adhesive film for a semiconductor may be improved.

A curing agent (C) used in the present invention is preferably a compound represented by formula (1). The compound represented by formula (1) is a polycondensation product of an allylphenol with formaldehyde, specifically a polycondensation product of 2-(2-propenyl)phenol.

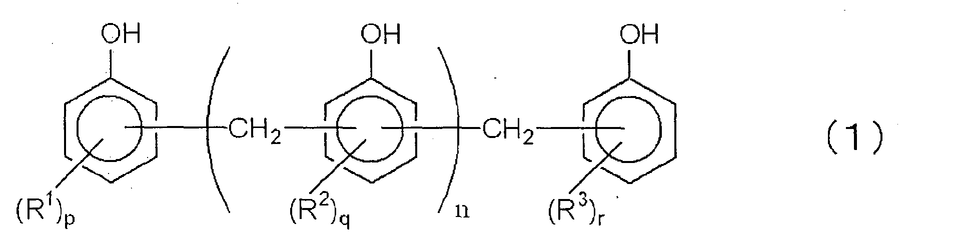

wherein p, q and r represent an integer of 1 to 3, and R¹, R² and R³ represent an allyl group.

In the present invention, it is also possible to add a solid phenol resin as a curing agent (C). Combining a solid phenol resin may lead to reduction in tackiness of an adhesive film for a semiconductor at room temperature, resulting in improved workability. Furthermore, the solid phenol resin refers to a general monomer, oligomer or polymer having at least two phenolic hydroxy groups which is capable of forming a cross-linked structure after a curing reaction with an epoxy resin (B) and is a solid at 25 °C and an ambient pressure; for example, phenolnovolac resins, cresol novolac resins, phenolaralkyl (containing a phenylene or biphenylene skeleton) resins, naphtholaralkyl resins, triphenolmethane resins, dicyclopentadiene type phenol resins, which may be used alone or in combination of two or more.

The above resin composition may contain, if necessary, a curing accelerator for accelerating a curing reaction. Specific examples of a curing accelerator include amine type catalysts such as imidazoles and 1,8-diazabicyclo(5,4,0)undecene; and phosphorous type catalysts such as triphenylphosphine.

Anadhesive film layer of the present inventionmay, if necessary, further contain a coupling agent. It may improve adhesiveness of the resin to a bonded material or to a resin.

A coupling agent may be a silane, titanium or aluminum type, particularly preferably a silane type coupling agent. Examples of a coupling agent include vinyltrichlorosilane, vinyltrimethoxysilane, vinyltriethoxysilane, β-(3,4-epoxycyclohexyl)ethyltrimethoxysilane, γ-glycidoxypropyltrimethoxysilane, γ-glycidoxypropylmethyldimethoxysilane, γ-methacryloxypropyltrimethoxysilane, γ-methacryloxypropylmethyldiethoxysilane, γ-methacryloxypropyltriethoxysilane, N-β(aminoethyl)γ-aminopropylmethyldimethoxysilane, N-β(aminoethyl)γ-aminopropyltrimethoxysilane, N-β(aminoethyl)γ-aminopropyltriethoxysilane, γ-aminopropyltrimethoxysilane, γ-aminopropyltriethoxysilane, N-phenyl-γ-aminopropyltrimethoxysilane, γ-chloropropyltrimethoxysilane, γ-mercaptopropyltrimethoxysilane, 3-isocyanatopropyltriethoxysilane and 3-acryloxypropyltrimethoxysilane.

A content of the above coupling agent is, but not limited to, preferably 0.01 parts by weight or more, particularly preferably 0.1 parts by weight or more to 100 parts by weight of the above acrylate copolymer. Thus, adhesiveness may be further effectively improved. The content is preferably 10 parts by weight or less. Thus, outgassing or void formation may be prevented.

The above resin composition may contain, if necessary, a cyanate-containing organic compound as an additional component. Thus, adhesiveness to a bonded material and heat resistance may be further improved.
Examples of the cyanate-containing organic compound include bisphenol-A dicyanate, bisphenol-F dicyanate, bis(4-cyanatophenyl) ether, bisphenol-E dicyanate and cyanatonovolac resins.

An adhesive film for a semiconductor of the present invention may be prepared, for example, by dissolving the above resin composition in a solvent such as methyl ethyl ketone, acetone, toluene and dimethylformaldehyde to prepare a varnish, applying the varnish to a release sheet using a comma coater, a die coater, a gravure coater or the like, drying it and then removing the release sheet.
A thickness of the adhesive film for a semiconductor is, but not limited to, preferably 3 µm to 100 µm both inclusive, particularly preferably 5 µm to 70 µm both inclusive. When the thickness is within the above range, a thickness may be particularly precisely controlled.

### EXAMPLES

There will be described Examples and Comparative Examples of an adhesive film for a semiconductor.

### (Example 1)

### (1) Preparation of a varnish of an adhesive film for a semiconductor resin

In methyl ethyl ketone (MEK) were dissolved 100 parts by weight of an acrylate copolymer (butyl acrylate-acrylonitrile-ethyl acrylate-glycidyl methacrylate copolymer, Nagase ChemteX Corp., SG-80HDR, Tg: 10 °C, weight-average molecular weight: 350,000) as a thermoplastic resin (A), 97 parts by weight of epoxy resin (EOCN-1020-80(ortho-cresol novolac type epoxy resin), epoxy equivalent 200 g/eq, Nippon Kayaku Co., Ltd.) as a hardening resin, 146 parts by weight of NC6000 (epoxy equivalent 200 g/eq, Nippon Kayaku Co., Ltd.), 110 parts by weight of a liquid phenol compound (MEH-8000H, hydroxy equivalent 141 g/OH group, Meiwa Plastic Industries, Ltd.), 47 parts by weight of a solid phenol resin (PR-HF-3, hydroxy equivalent 104 g/OH group, Sumitomo Bakelite Co. , Ltd.), 0.75 parts by weight of an imidazole compound (2P4MHZ-PW, Shikoku Chemicals Corp.) as a curing accelerator and 1.3 parts by weight of γ-glycidoxypropyltrimethoxysilane (KBM403E, Shin-Etsu Chemical Co., Ltd.) as a coupling agent, to prepare a resin varnish with a resin solid content of 49 %.

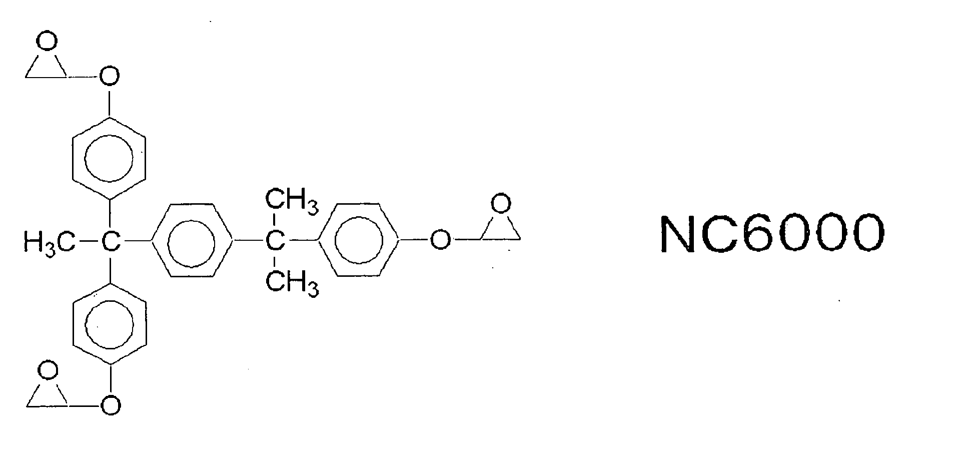

### (2) Preparation of an adhesive film for a semiconductor

The above resin varnish was applied to a polyethylene terephthalate film (Mitsubishi Polyester Film Corp., Catalogue No.: MRX50, thickness 50 µm) as a base material film (I) using a comma coater, and then dried at 90 °C for 5 min, to give an adhesive film for a semiconductor with a thickness of 25 µm.

### (3) Preparation of a base material film (II) and a glue layer

Cleartech CT-H717 (Kuraray Co., Ltd.) consisting of 60 parts by weight of HYBRAR(registered trademark ) and 40 parts by weight of polypropylene was shaped by an extruder into a film with a thickness of 100 µm as a base material film (II), whose surface was then corona-treated. Next, to a release treated polyester film with a thickness of 38 µm was applied a copolymer having a weight-average molecular weight of 500,000 prepared by copolymerizing 50 parts by weight of 2-ethylhexyl acrylate and 10 parts by weight of butyl acrylate, 37 parts by weight of vinyl acetate and 3 parts by weight of 2-hydroxyethyl methacrylate such that a thickness after drying was to be 10 µm, and the film was dried at 80 °C for 5 min, to give a glue layer. Then, the glue layer was laminated on the corona-treated surface of the base material film (II) to give a glue layer with the base material film (II).

### (4) Preparation of a dicing die attach film

A protective film was laminated to the above adhesive film layer with the base material film (I), and the base material film (I) and the adhesive film layer were half-cut, which were laminated to the above glue layer on the base material film (II). The protective film was removed to give a dicing die attach film in which are laminated the base material film (II), the glue layer, the base material film (I) and the adhesive film layer in sequence.

### (5) Preparation of a semiconductor device

A dicing die attach film prepared in each of Examples and Comparative Examples was attached to the rear surface of a five-inch 200 µm wafer at 60 °C, to give a wafer with a dicing die attach film. Then, the wafer with the dicing die attach film was diced (cut) into 5 mm × 5 mm square semiconductor elements using a dicing saw at a spindle frequency of 30,000 rpm and a dicing rate of 50 mm/sec. Then, an e element was pushed from the back side of the dicing-sheet-acting dicing sheet to separate the base material film (II) from the adhesive film layer. The semiconductor element having the die attach film was bonded to a bismaleimide-triazine resin substrate (circuit step: 5 to 10 µm) coated with a solder resist (Taiyo Ink Mfg. Co., Ltd., trade name: AUS308) at 130 °C and 5N for 1.0 sec, and the semiconductor adhesive film was half-cured by heating at 120 °C for one hour. Then, the element was encapsulated by a resin and heated at 175 °C for two hours, and the encapsulation resin was cured to give a semiconductor device. Ten devices were prepared.

There will be detailed evaluation tests of an adhesive film for a semiconductor of the present invention.

### (Method for determining a minimum melt viscosity)

Several adhesive films for a semiconductor were laminated to a thickness of 100 µm to prepare a sample, to which was then applied a shear force at a frequency of 1 Hz and at a temperature-rise rate of 10 °C/min using HAAKE Corp. Rheostress RS-150.

### (Method for measuring volatiles)

An adhesive film for a semiconductor with a size of 50 × 50 mm was used as a sample with a measured weight of M1, which was heated in a hot-air circulating thermostatic oven at 200 °C for 2 hours, and then weighed (M2). A content of volatiles was calculated using the equation, [(M2-M1)/M1]×100 = volatile content (wt %).

### (Method for determining a die shear strength after adhesion)

An adhesive film for a semiconductor was sandwiched between a 4×4 mm silicon chip (thickness: 550 µm) and a bismaleimide-triazine substrate coated with a solder resist (Taiyo Ink Mfg. Co., Ltd., trade name: AUS308), and the sample was bonded at 130 °C and 5N for one second, and subsequently heated at 120 °C for one hour and then at 175 °C for two hours. The sample was held on a hot plate at 260 °C for 20 sec, and then a shear stress was applied to the sample at a rate of 0.5 mm/min using a push-pull gauge, to determine a shear strength as a die shear strength.

### (Circuit-filling ability)

Circuit-filling ability was evaluated as a filling rate of a circuit step on an organic substrate in a semiconductor device before resin encapsulatin, with an adhesive film for a semiconductor as determined by a scan acoustic tomograph (SAT). Symbols have the following meanings.
⊚:filling rate = 100 %
○: filling rate = 80 % or more and less than 100 %
△: filling rate = 40 % or more and less than 80 %
×: filling rate = less than 40 %

There will be detained evaluation tests for a semiconductor device prepared using an adhesive film for a semiconductor of the present invention.

### (Adhesiveness after wetting treatment)

A semiconductor device before resin sealing prepared in each of Examples and Comparative Examples was moisture-treated under the conditions of 85 °C/85 % RH/168 hours, and a shear strength at 260 °C was evaluated between a semiconductor element and an organic substrate.
⊚: shear strength = 1.0 MPa or more
○: shear strength = 0.75 MPa or more and less than 1.0 MPa
△: shear strength = 0.5 MPa or more and less than 0.75 MPa
×: shear strength = less than 0.5 MPa

### (Crack resistance)

A semiconductor device prepared in each of Examples and Comparative Examples was moisture-treated under the conditions of 85 °C/85 % RH/168 hours, subjected to IR reflow at 260 °C three times and then evaluated for its crack resistance by a scanning acoustic tomograph (SAT). Symbols have the following meanings.
⊚: crack number = zero per 10
○: crack number = 1 to 3 both inclusive per 10
△: crack number = 4 to 9 both inclusive per 10
×: crack number = 10 per 10

Table 1 shows physical properties and various evaluation results for the adhesive films for a semiconductor prepared in Examples and Comparative Examples as well as evaluation results for semiconductor devices having the adhesives film for a semiconductor in detail.

**Table 1**

| | | Ex.1 | Ex.2 | Ex.3 | Ex.4 | Ex.5 | Ex.6 | Ex.7 | Comp. Ex.1 | Comp. Ex.2 | Comp. Ex.3 | Comp. Ex.4 | Comp. Ex.5 |
|---|---|---|---|---|---|---|---|---|---|---|---|---|---|
| Thermoplastic resin (A) | SG-80HDR (acrylate copolymer) | 100 | 100 | 100 | 100 | 100 | 100 | 100 | 100 | 100 | 100 | 100 | |
| | Polyimide resin | | | | | | | | | | | | 100 |
| Epoxy resin (B) | EOCN-1020-80 | 97 | 99 | 97 | 97 | 200 | 60 | 400 | | 200 | 200 | | 10 |
| | NC-6000 | 146 | 148 | 146 | 146 | | | | | | | 526 | |
| Liquid phenol compound (C) | MEH-8000H | 110 | 92 | | 110 | 141 | 42 | 282 | | | | 371 | |
| | MEH-8000-4L | | | 110 | | | | | | | | | |
| Solid phenol resin (D) | PR-HF-3 | 47 | 62 | 47 | | | | | | 104 | 104 | | |
| | PR53647 | | | | 47 | | | | | | | | |
| Curing accelerator (E) | 2P4MZ-PW (imidazole compound) | 0.75 | 0.75 | 0.75 | 0.75 | 0.75 | 0.75 | 0.75 | | 0.75 | 0.75 | 0.75 | |
| Coupling agent (F) | KBM403E | 1.3 | 1.3 | 1.3 | 1.3 | 1.3 | 1.3 | 1.3 | 1.3 | 1.3 | 1.3 | 1.3 | |
| | KBM573 | | | | | | | | | | | | 5 |
| UV curable monomer (G) | 1,6-HX | | | | | | | | | | 120 | | |
| Evaluation results of an adhesive film | Minimum melt viscosity from 50 to 180 °C | 18 | 45 | 25 | 60 | 0.8 | 240 | 0.2 | 2800 | 1800 | 10 | 0.01 | 4100 |
| | Temperature at a minimum melt viscosity (°C) | 151 | 160 | 154 | 155 | 148 | 163 | 144 | 180 | 180 | 165 | 160 | 180 |
| | Volatiles (wt%) | 2.6 | 2.4 | 3.8 | 2.4 | 4.1 | 1.8 | 4.2 | 1.5 | 2.9 | 9.1 | 4.9 | 1.0 |
| | Die shear strength after adhesion (MPa) | 2.9 | 3.2 | 2.5 | 3.4 | 2.0 | 4,2 | 2.3 | 0.7 | 2.4 | 3.3 | 1.4 | <0.1 |
| | Circuit filling ability | ⊚ | ⊚ | ⊚ | ⊚ | ⊚ | ⊚ | ⊚ | × | × | ⊚ | ⊚ | × |
| Evaluation results of a semiconductor device | Adhesiveness after wetting treatment (MPa) | 2.4 | 2.5 | 1.8 | 2.2 | 1.7 | 2.8 | 1.5 | 0.5 | 1.9 | 1.3 | 0.7 | <0.1 |
| | | ⊚ | ⊚ | ⊚ | ⊚ | ⊚ | ⊚ | ⊚ | × | ⊚ | ⊚ | △ | × |
| | Crack resistance (Crack number/10) | 0/10 | 0/10 | 0/10 | 0/10 | 0/10 | 0/10 | 0/10 | 10/10 | 10/10 | 10/10 | 10/10 | 10/10 |
| | | ⊚ | ⊚ | ⊚ | ⊚ | ⊚ | ⊚ | ⊚ | × | × | × | × | × |

### (Example 2)

An experiment was conducted as described in Example 1, except using 99 parts by weight of EOCN-1020-80 (epoxy equivalent 200 g/eq, Nippon Kayaku Co., Ltd.) as an epoxy resin, 148 parts by weight of NC6000 (epoxy equivalent 200 g/eq, Nippon Kayaku Co., Ltd.), 92 parts by weight of MEH-8000H (hydroxy equivalent 141 g/OH group, Meiwa Plastic Industries, Ltd.) as a liquid phenol compound (C) and 62 parts by weight of PR-HF-3 (hydroxy equivalent 104 g/OH group, Sumitomo Bakelite Co., Ltd.) as a solid phenol resin. Table 1 shows the composition and the experimental results.

### (Example 3)

An experiment was conducted as described in Example 1, except using 110 parts by weight of MEH-8000-4L (hydroxy equivalent 141 g/OH group, Meiwa Plastic Industries, Ltd.) as a liquid phenol compound (C). Table 1 shows the composition and the experimental results.

### (Example 4)

An experiment was conducted as described in Example 1, except using 47 parts by weight of PR53647 (hydroxy equivalent 104 g/OH group, Sumitomo Bakelite Co., Ltd.) as a solid phenol resin. Table 1 shows the composition and the experimental results.

### (Example 5)

An experiment was conducted as described in Example 1, except using 200 parts by weight of EOCN-1020-80 (epoxy equivalent 200 g/eq, Nippon Kayaku Co., Ltd.) as an epoxy resin and 141 parts by weight of MEH-8000H (hydroxy equivalent 141 g/OH group, Meiwa Plastic Industries, Ltd.) as a liquid phenol compound (C). Table 1 shows the composition and the experimental results.

### (Example 6)

An experiment was conducted as described in Example 1, except using 60 parts by weight of EOCN-1020-80 (epoxy equivalent 200 g/eq, Nippon Kayaku Co., Ltd.) as an epoxy resin (B) and 42 parts by weight of MEH-8000H (hydroxy equivalent 141 g/OH group, Meiwa Plastic Industries, Ltd.) as a liquid phenol compound (C). Table 1 shows the composition and the experimental results.

### (Example 7)

An experiment was conducted as described in Example 1, except using 400 parts by weight of EOCN-1020-80 (epoxy equivalent 200 g/eq, Nippon Kayaku Co., Ltd.) as an epoxy resin (B) and 282 parts by weight of MEH-8000H (hydroxy equivalent 141 g/OH group, Meiwa Plastic Industries, Ltd.) as a liquid phenol compound (C). Table 1 shows the composition and the experimental results.

### (Example 8)

The side of an adhesive film for a semiconductor prepared in each of Examples and Comparative Examples was laminated to the back side of a five-inch 200 µm semiconductor wafer under the conditions of 60 °C, 0.1 MPa and 50 mm/sec, and the side of the adhesive film for a semiconductor was fixed on a dicing film (Sumilite(registered trademark ) FSL-N4003, Sumitomo Bakelite Co., Ltd.). Then, the semiconductor wafer having the adhesive film for a semiconductor was diced (cut) into 5 mm × 5 mm square semiconductor elements using a dicing saw at a spindle frequency of 30, 000 rpm and a cutting rate of 50 mm/sec, to obtain semiconductor elements having the adhesive film for a semiconductor. Then, an element was irradiated with ultraviolet rays to amount of exposure of 250 mJ/ cm² for 20 sec from the side of the optically-transparent base material in the dicing film, and then an element was pushed from the back side of dicing film. Next, the semiconductor element having the adhesive film for a semiconductor was bonded to a bismaleimide-triazine-based organic substrate (surface gap: 5 to 10 µm) coated with a solder resist (Taiyo Ink Mfg. Co., Ltd. , AUS308) at 130 °C and 5 N for 1.0 sec and heated at 120 °C for 1 hour, to half-cure the semiconductor adhesive film. The element was encapsulate with a resin and heated at 175 °C for 2 hours for curing the encapsulation resin, to give a semiconductor device. FIG. 2 schematically shows the semiconductor device thus obtained. It was found that this semiconductor device exhibited higher reliability in various evaluation tests.

### (Comparative Example 1)

An experiment was conducted as described in Example 1, except that an epoxy resin (B), a liquid phenol compound (C), a solid phenol resin or a curing accelerator were not added. Table 1 shows the composition and the experimental results.

### (Comparative Example 2)

An experiment was conducted as described in Example 1, except that an epoxy resin (B) was 200 parts by weight of EOCN-1020-80 (epoxy equivalent 200 g/eq, Nippon Kayaku Co. , Ltd.) and a solid phenol resin was 104 parts by weight of PR-HF-3 (hydroxy equivalent 104 g/OH group, Sumitomo Bakelite Co., Ltd.), and a liquid phenol compound (C) was not added. Table 1 shows the composition and the experimental results.

### (Comparative Example 3)

An experiment was conducted as described in Example 1, except that an epoxy resin (B) was 200 parts by weight of EOCN-1020-80 (epoxy equivalent 200 g/eq, Nippon Kayaku Co., Ltd.), a solid phenol resin was 104 parts by weight of PR-HF-3 (hydroxy equivalent 104 g/OH group, Sumitomo Bakelite Co., Ltd.), an UV curable monomer was 120 parts by weight of 1,6-hexanediol dimethacrylate (1,6-HX, Manufacturer: Kyoeisha Chemical Co., LTD) and a liquid phenol compound (C) was not added. Table 1 shows the composition and the experimental results.

### (Comparative Example 4)

An experiment was conducted as described in Example 1, except that an epoxy resin (B) was 526 parts by weight of NC6000 (epoxy equivalent 200 g/eq, Nippon Kayaku Co., Ltd.) and a liquid phenol compound (C) was 371 parts by weight of MEH-8000H (hydroxy equivalent 141 g/OH group, Meiwa Plastic Industries, Ltd.), and a solid phenol resin was not added. Table 1 shows the composition and the experimental results.

### (Comparative Example 5)

In N-methyl-2-pyrrolidone (NMP) were dissolved 100 parts by weight of a polyimide resin (a polyimide resin prepared using 43.85 g (0.15mol) of 1,3-bis(3-aminophenoxy)benzene (Mitsui Chemicals, Inc., APB) as a diamine component and 125.55 g (0.15 mol) of α,ω-bis(3-aminopropyl)polydimethylsiloxane (average molecular weight: 837) (Fuso Chemical Co., Ltd., G9) and 93.07 g (0.30 mol) of 4,4'-oxydiphthalic dianhydride (Manac Incorporated, ODPA-M) as an acid component, Tg: 70 °C, weight-average molecular weight 30,000) as a thermoplastic resin (A), 10 parts by weight of (EOCN-1020-80 (ortho-cresol novolac type epoxy resin), epoxy equivalent 200 g/eq, Nippon Kayaku Co., Ltd.) as an epoxy resin (B) and 5 parts by weight of N-phenyl-γ-aminopropyltrimethoxysilane(KBM573,Shin-Etsu Chemical Co. , Ltd.) as a coupling agent, to prepare a resin varnish with a resin solid content of 43 %. The varnish was applied to a protective film, a polyethylene terephthalate film (Mitsubishi Polyester Film Corp., Catalogue No. : MRX-50, thickness 50 µm), which was then dried at 180 °C for 10 min, to prepare an adhesive film for a semiconductor with a thickness of 25 µm. The film was used for evaluation. The experimental results are shown in Table 1.

As shown in Table 1, Examples 1 to 7 exhibited good results in both adhesive film evaluation and semiconductor device evaluation, while any of Comparative Examples 1 to 5 exhibited no good results.
Particularly, in Comparative Example 4, a minimum melt viscosity was as low as 0.1 Pa·s or less, so that the adhesive film flew out from the bonding site during semiconductor chip lamination, leading to inappropriate lamination of the semiconductor chip.

## Claims

1. An adhesive film for a semiconductor, comprising a thermoplastic resin (A), an epoxy resin (B) and a curing agent (C),
wherein a minimum melt viscosity of said adhesive film for a semiconductor is 0.1 Pa·s to 500 Pa·s both inclusive in a temperature range of 50 °C to 180 °C both inclusive at a temperature-rise rate of 10 °C/min from room temperature and a content of volatile component is 5.0 % or less.

2. The adhesive film for a semiconductor as claimed in Claim 1, wherein a die shear strength after adhesion is 1 MPa or more.

3. The adhesive film for a semiconductor as claimed in Claim 1 or 2, wherein said thermoplastic resin (A) is an acrylic resin.

4. The adhesive film for a semiconductor as claimed in any of Claims 1 to 3, wherein said thermoplastic resin (A) is a compound having at least one selected from an epoxy group, a hydroxy group, a carboxyl group and a nitrile group.

5. The adhesive film for a semiconductor as claimed in any of Claims 1 to 4, wherein said thermoplastic resin (A) has a weight-average molecular weight of 100,000 to 1,000,000 both inclusive.

6. The adhesive film for a semiconductor as claimed in any of Claims 1 to 5, wherein said thermoplastic resin (A) has a glass-transition temperature of -20 °C to 60 °C both inclusive.

7. The adhesive film for a semiconductor as claimed in any of Claims 1 to 6, satisfying the equation 0.1≤a/(a+b+c)≤0.5 where a content of said thermoplastic resin (A) is "a" parts by weight, a content of said epoxy resin (B) is "b" parts by weight and a content of said curing agent (C) is "c" parts by weight.

8. The adhesive film for a semiconductor as claimed in any of Claims 1 to 7, wherein a content of said epoxy resin (B) is 10 parts by weight to 100 parts by weight both inclusive to 10 parts by weight of said thermoplastic resin (A).

9. The adhesive film for a semiconductor as claimed in any of Claims 1 to 8, wherein said curing agent (C) is a phenol resin.

10. The adhesive film for a semiconductor as claimed in Claim 9, wherein said phenol resin is liquid at 25 °C.

11. A semiconductor device having a structure where a semiconductor element is attached to a bonded member using the adhesive film for a semiconductor as claimed in any of Claims 1 to 10.

12. The semiconductor device as claimed in Claim 11, wherein a shear strength after moisture treatment is 1 MPa or more.
